# EUROPÄISCHE PATENTSCHRIFT

(11) **EP 3 523 829 B1**
(45) Veröffentlichungstag und Bekanntmachung des Hinweises auf die Patenterteilung: **06.09.2023**
(21) Anmeldenummer: 17749113.1
(22) Anmeldetag: 11.07.2017
(51) Int. Cl.: H01L 31/0352, H01L 31/0312, H01L 31/0224, H01L 31/05, H01L 21/02

(54) **RAUMTEMPERATUR-DRUCKVERFAHREN ZUR HERSTELLUNG EINER PV-SCHICHTFOLGE UND VERFAHRENSGEMÄSS ERHALTENE PV-SCHICHTFOLGE**
ROOM TEMPERATURE PRINTING METHOD FOR PRODUCING A PV LAYER SEQUENCE AND PV LAYER SEQUENCE OBTAINED USING THE METHOD
PROCÉDÉ D'IMPRESSION À TEMPÉRATURE AMBIANTE SERVANT À LA PRODUCTION D'UNE SUCCESSION DE COUCHES PV ET SUCCESSION DE COUCHES PV OBTENUE SELON LE PROCÉDÉ

(30) Priorität: 12.07.2016 DE 102016008383
(43) Veröffentlichungstag der Anmeldung: 14.08.2019
(73) Patentinhaber: Dynamic Solar Systems AG, 60308 Frankfurt am Main (DE)
(72) Erfinder: LINDER, Daniel, 91611 Lehrberg (DE); LINDER, Patrick, 91611 Lehrberg (DE)
(74) Vertreter: Kreuzkamp, Markus
(86) Internationale Anmeldenummer: PCT/DE2017/100572
(87) Internationale Veröffentlichungsnummer: WO 2018/010727

(56) Entgegenhaltungen:
- EP-A1- 0 866 506
- US-A1- 2010 167 441
- US-A1- 2013 153 027
- NEGAR SANI ET AL: "Flexible Lamination-Fabricated Ultra-High Frequency Diodes Based on Self-Supporting Semiconducting Composite Film of Silicon Micro-Particles and Nano-Fibrillated Cellulose", SCIENTIFIC REPORTS, Bd. 6, Nr. 1, 30. Juni 2016 (2016-06-30), Seiten 1-8, XP055419784, DOI: 10.1038/srep28921

## Beschreibung

### TECHNISCHER HINTERGRUND

Der technische Bereich kann im Allgemeinen mit dem Begriff 'elektrotechnische Dünnschichten' umrissen werden. Solche Dünnschichten sind Bruchteile von Mikrometern bis mehrere 100 Mikrometer dick und finden bei der Erzeugung, Verarbeitung, Steuerung, Regelung, Messung und Weiterleitung von Strom Anwendung.

Konkret stellt die vorliegende Erfindung auf photovoltaische, elektrotechnische Systeme ab, in denen Strom aus Photonen erzeugt wird. 'Photovoltaisch' sowie 'Photovoltaik' wird dabei - wie auch nachfolgend - häufig schlicht mit 'PV' abgekürzt. Die Anmelderin ist mit mehreren, verbundenen Unternehmen im PV-Bereich schon länger tätig. Veranschaulichend sei auf die WO 2014-019560 A1 hingewiesen, welche zusammen mit den in dieser Schutzrechtsfamilie angeführten und recherchierten Dokumenten als grundsätzlicher, technischer Hintergrund für gedruckte Systeme im hier relevanten, technischen PV-Bereich angesehen werden kann.

Ausgehend von den bekannten und etablierten Systemen hat die Anmelderin Verfahren und Produkte dahingehend erforscht und entwickelt, dass diese mit möglichst niedrigen Produktionskosten robust und langfristig PV-Energie gewinnen, verarbeiten, speichern und nutzen können. Veranschaulichend sei auf die Schutzrechtsfamilien der DE 10 2015 102 801.8, DE 10 2015 01 5435.4, DE 10 2015 01 56 00.4 und DE 10 2016 002 213.2 A hingewiesen, deren technische Lehre das Fundament der vorliegenden Erfindung waren und das relevante Können und Wissen sinnvoll umreißen. Vorbereitend werden Lehre und Kernkomponenten der vorgenannten Schutzrechte im Lichte des Standes der Technik nachfolgend grob umrissen werden.

### BESCHREIBUNG DES STANDES DER TECHNIK

Die vorliegende Erfindung betrifft ein Raumtemperatur-Verfahren zur Herstellung einer PV-Schichtfolge und die verfahrensgemäße PV-Schichtfolge gemäß den Oberbegriffen der unabhängigen Ansprüche.

Als eine wesentliche Komponente der vorliegenden Erfindung hat sich die Fertigung anorganischer Kernkomponenten bei Raumtemperatur mit wässrigen Dispersionen und Lösungen herausgestellt:
Anorganische Kernkomponenten sind erheblich länger haltbar als entsprechende, organische Systeme.

Organische PV-Schichtfolgen halten wenige Tage bis Monate. Organische PV-Komponenten, wie sie auch in der Veröffentlichung ,SCIENTIFIC REPORTS 6:28921 DOI:10.1038/srep28921' , offenbart sind, haben auf Grund der leitfähigen, organischen Anteile häufig geringere Lebenserwartungen und geringere Aussicht auf hoch stabile Leistungswerte innerhalb eines Lebenszyklus. Abweichend dazu ist die vorliegende Erfindung auf anorganische Halbleiter-Strukturen ausgerichtet.

Anorganische, PV-aktive Komponenten zeigten in genormten Klimakammertests bei bis zu 30 Jahren simulierter Lebenszeit stets mindestens 90% der Anfangsleistung; bei den entsprechenden Tests versagten organische Stell-, Hilfs- und Zusatzstoffe wie zum Beispiel polymere Einbettmasse des Glas-Glas-Trägers oder der organischer Faser-Verbundträger der PV-aktiven Dünnschichtkombination, aber die Strom erzeugende Kernkomponente mit ihren metallischen Zuleitungen erfüllte trotz eines stark verwitterten und unansehnlichen Gesamtprodukts nach wie vor die gewünschte Funktion und lieferte Strom. Dies führen die Erfinder auf die anorganische Natur der Kernkomponenten der PV-Schichtfolge zurück, welche naturgemäß keine Polymere oder organischen Kohlenwasserstoffverbindungen aufweisen.

Raumtemperatur-Verfahren konnten durch reaktive Systeme ermöglicht werden, welche chemische Reaktions-Energie zur Ausbildung und Einstellung der Schichten einbringen. 'Raumtemperatur' umfasst dabei übliche Temperaturbereiche einer industriellen Fertigung, die je nach Standort einer Fabrik zwischen wenigen Grad Celsius über Null bis hin zu 80 Grad Celsius liegen können. Hierbei zeigte sich, dass die bei Raumtemperatur ablaufenden Reaktionen im Vergleich zu Verfahren mit bekanntem Kompaktierungs- und/oder Sinter-Schritt deutlich breitere und teilweise extrem abweichende Bandlücken-Strukturen bereitstellen. So konnte erstmals eine Schichtstruktur erzeugt werden, welche mit engem Wellenlängenbereichs-Fenster spezifisch Kontakt-Wärmestrahlung von warmem Wasser in Strom umzuwandeln vermochte.

Wässrige Dispersionen und Lösungen sind im PV-Markt nicht etabliert. Die üblichen und in der Herstellung anspruchsvollen Si-Wafer vertragen keine Feuchtigkeit. Insbesondere Anbieter von Leit-Pasten und leitfähigen, aufbringbaren Elektrodenmassen sehen sich häufig mit der Anforderung konfrontiert, komplett wasserfreie Systeme bereitzustellen, welche in Vakuum-Systemen abschließend bei mindestens 150°C parallel zu Beschichtungs- oder Aufdampfungs-Schritten kompaktiert und gesintert werden können. Damit übereinstimmend sehen auch partikuläre, PV-aktive Strukturen wie sie in der US 2013/153027 A1, der US 2010/167441 A1 oder der EP 0 866 506 A1 offenbart sind, Sinterschritte bei erhöhten Temperaturen vor, um Halbleiter stoffschlüssig und dauerhaft durch Sinterprozesse mit einem weiteren Material unter Einstellung der Leitungstyp-Charakteristik zu koppeln. Nachteilig benötigt der Sinterschritt zur Erlangung einer dauerhaften, eingestellten Leitfähigkeit eine gezielt eingestellte, erhöhte Temperatur, die in einem nachteiligen, zusätzlichen Verfahrensschritt mit zusätzlichen Kosten bereitgestellt werden muss.

Darauf führen die Erfinder zurück, dass bekannte Drucksysteme und drucktechnische Lösungen, die auf wässrigen Pasten aufbauen, hier keine Verbreitung finden. In Kombination mit der Maßnahme 'Raumtemperatur' können solche alten Methoden aber wider Erwarten Anwendung finden: PV-aktive Halbleiter, Metall-Nichtmetall-Verbindungen sowie Metall-Metallchalkogenid und auch Metall-Metallhalogenid-Verbindungen erwiesen sich bei Temperaturen von weniger als 100 Grad Celsius als ausreichend stabil, selbst wenn Sie in wässrige Dispersionen oder Lösungen eingearbeitet und verdruckt wurden.

Bekannte Drucksysteme und drucktechnische Lösungen umfassen hierbei Maßnahmen, Merkmale und Stell- und Hilfsstoffe wie sie in den vorgenannten Anmeldungen angeführt sind und auch zum Beispiel in den drucktechnischen Dokumenten DE 122 1651 A, DE 2012 651 B, DE 2529 043 B2, DE 10004997 A, DE 1 907 582 B, DE 2 017 326 A, DE 23 45 493 C2, GB 1 449 821 A, DE 27 33 853 A, DE 34 47 713 A, JP H043 688 87 A, JP H06 001 852 A und DE 43 22 999 A1 offenbart werden. Insbesondere die DE 197 20 004 C1 verdient hier Erwähnung, da dieses Dokument die sequentielle Verwendung von aufeinander abgestimmten Farb-Reaktivtinten in Tintenstrahl-Druckverfahren offenbart, was parallel zu den vorliegend entwickelten, elektrotechnischen Reaktivdruck-Maßnahmen gesehen werden kann und technisch die Umsetzbarkeit von Reaktivdrucksystemen durch bekannte, drucktechnische Maßnahmen belegt.

Den Erfindern ist jedoch aus dem Wettbewerb kein Druckverfahren der gattungsgemäßen Art bekannt, welches konsequent auf die Herstellung einer vollständigen, anorganischen PV-Schichtfolge inklusive elektrischen Zu- und Ableitungen, welche eine Kontaktierung erst vervollständigen, bei Raumtemperatur abstellt.

Nachteilig werden im Stand der Technik stets Pasten oder Materialien als Bestandteil der PV-Schichtfolge vorgesehen, die entweder schädliche organische Lösungsmittel enthalten und/oder toxische Schwermetalle wie zum Beispiel Blei, Cadmium oder Selen umfassen und/oder bei Temperaturen von um die 100 °C und mehr gesintert/kompaktiert werden müssen, bevor eine PV-aktive Schichtfolge inklusive Strom abnehmenden Leitern und kompletter Kontaktierung vorliegt. Kein Dokument offenbart eine vollständige und geschlossene Lehre, wie bei Raumtemperatur eine komplette PV-Schichtfolge inklusive Elektroden in applizierbarer Form erhalten werden könnte. Weiterhin nachteilig ist, dass die etablierten PV-Schichtfolgen stets auf teure, sehr reine Ausgangsstoffe zurückgreifen müssen, um zuverlässig PV-Aktivität bereitstellen zu können.

Insbesondere erweist sich der klassische Schicht-Aufbau einer PV-Schichtfolge, bei dem eine unterseitige, erste Elektrode eine PV-aktive Schicht auf einer ersten Seite kontaktiert und die zweite Seite als Gegenseite von einer oberseiteigen Gegenelektrode zu kontaktieren ist, als nachteilig: Poren, Pinholes und Durchbrüche in der PV-aktiven Schicht machen eine oberseitige Kontaktierung mit flüssigen oder pastösen Systemen nahezu unmöglich, da diese über die Durchbrüche und Defekte die beiden Elektrodenschichten miteinander kurzschließen können, wodurch die PV-Aktivität in großen, flächigen Bereichen nicht mehr sinnvoll in Strom umsetzbar ist: Der PV-Strom fließt über den Kurzschluss/Durchbruch direkt zur Gegenseite der PV-aktiven Schicht und ist nicht mehr nutzbar; die Schicht heizt sich durch den PV-Strom auf und der elektrotechnische Verschleiß lässt das betroffene Areal erheblich altern und frühzeitig verwittern.

Aufgabe der vorliegenden Erfindung war es daher, die Nachteile des Standes der Technik zu überwinden und ein Verfahren sowie eine verfahrensgemäße PV-Schichtfolge bereitzustellen, welche trotz industrieller Prozessführung bei Raumtemperatur, anorganischen Kernkomponenten und unter Verwendung wässriger Lösungen und/oder wässriger Dispersionen eine vollständige PV-Schichfolge als Teil eines fertigen, kontaktierbaren Schichtverbunds bereitstellen.

Die Lösung dieser Aufgabe erfolgt gemäß der Merkmale der unabhängigen Ansprüche 1 und 9.

Vorteilhafte Ausführungsformen ergeben sich aus den abhängigen Ansprüchen sowie der nachfolgenden Beschreibung.

### ZUSAMMENFASSUNG DER ERFINDUNG

Erfindungsgemäß ist ein Verfahren zur Herstellung einer PV-Schichtfolge, bei dem - bei Raumtemperatur, - anorganische Kernkomponenten unter Verwendung wässriger Lösungen und/oder wässriger Dispersionen per Druckverfahren zu einer vollständigen, über Elektroden kontaktierbaren PV-Schichfolge verarbeitet werden, dadurch gekennzeichnet, dass das Verfahren die Schritte umfasst, dass in einem Schritt a) 0,5 bis 100 Mikrometer große, halbleitende Partikel 100, welche aus mindestens zwei Elementen bestehen, in einer wässrigen Reaktionslösung 200 dispergiert, oxidativ oder reduktiv angelöst und flächig auf einen Träger 300 aufgebracht werden, in einem Schritt b) die Reaktionslösung 200 unter Volumenkontraktion zu einer ausgehärteten Reaktions-Lösungsschicht 201 umgewandelt wird, wobei die Partikel 100 über die ausgehärtete Reaktions-Lösungsschicht 201 hinausragen und eine in der Reaktions-Lösungsschicht 201 verankerte Unterseite und eine über die Reaktions-Lösungsschicht 201 hinausragende Oberseite aufweisen und in einem Schritt c) die Oberseite der Partikel zumindest abschnittsweise mit einem Oberseiten-Kontakt 400 versehen wird, wobei im Schritt b) weiterhin aneinander angrenzende Flächenabschnitte der Partikel 100 mit unterschiedlichen Lösungen konditioniert werden, wodurch die aneinander angrenzenden Flächenabschnitte der Partikel (100) in abwechselnder Reihenfolge als Abschnitte reduktiv behandelter Partikel (102) und Abschnitte oxidativ behandelter Partikel (103) ausgebildet werden.

Eine erfindungsgemäße PV-Schichtfolge wird durch das vorbeschriebene Verfahren erhalten und ist durch Partikel 100 gekennzeichnet, welche in flächigen Abschnitten auf einen Träger aufgedruckt sind und durch die begleitende, chemische Reaktion in ihrem PV-Verhalten eingestellt sind. Die PV-Schichtfolge weist eine bei Raumtemperatur ausgehärtete, wässrige Reaktions-Lösungsschicht auf, wobei Partikel aus anorganischen Kernkomponenten über die ausgehärtete Reaktions-Lösungsschicht hinausragen und eine in der Reaktions-Lösungsschicht verankerte Unterseite und eine über die Reaktions-Lösungsschicht hinausragende Oberseite aufweisen, die PV-Schichtfolge weiterhin umfassend aufgedruckte Elektroden, welche die PV-Schichfolge kontaktieren, wobei wiederum als Partikel 0,5 bis 100 Mikrometer große, halbleitende Partikel, oxidativ oder reduktiv angelöst und flächig auf einem Träger angeordnet sind, die Oberseite der Partikel zumindest abschnittsweise mit einem Oberseiten-Kontakt versehen ist, aneinander angrenzende Flächenabschnitte der Partikel mit unterschiedlichen Lösungen konditioniert sind, wodurch die aneinander angrenzenden Flächenabschnitte der Partikel in abwechselnder Reihenfolge als Abschnitte reduktiv behandelter Partikel und Abschnitte oxidativ behandelter Partikel angeordnet sind.

### BESCHREIBUNG DER ERFINDUNG UND VORTEILHAFTER MERKMALE

Das erfindungsgemäße Verfahren zur Herstellung einer PV-Schichtfolge baut auf dem bereits Entwickelten auf und sieht zunächst vor, dass bei Raumtemperatur anorganische, PV-aktive Kernkomponenten unter Verwendung wässriger Lösungen und/oder wässriger Dispersionen per Druckverfahren zu einer vollständigen, über Abnehmer-Elektroden kontaktierbaren PV-Schichfolge verarbeitet werden.

Wesentlich ist, dass das Verfahren die Schritte umfasst, dass in einem Schritt a) 0,5 bis 100 Mikrometer große, halbleitende Partikel 100, welche aus mindestens zwei Elementen bestehen, in einer wässrigen Reaktionslösung 200 dispergiert, oxidativ oder reduktiv angelöst und flächig auf einen Träger 300 aufgebracht werden. Das aus mindestens zwei Elementen bestehende, PV-aktive Material wird durch das Anlösen aktiviert und in seiner Stöchiometrie geändert. Eine zuvor gleichmäßige und einheitliche Dotierung oder Zusammensetzung erfährt dadurch in dünner, äußerer Schicht eine erhebliche Modifikation. Diese Modifikation ist bei Raumtemperatur kinetisch kontrolliert und es bilden sich die am schnellsten zugänglichen Phasen und Verbindungen, was Produkte zur Folge hat, welche zumindest metastabiler Natur sind und erheblich von den thermodynamisch stabilen Produkten abweichen.

In einem Schritt b) wird die aufgedruckte Reaktionslösung 200 unter Volumenkontraktion zu einer ausgehärteten Reaktions-Lösungsschicht 201 umgewandelt. Die Schicht war zuvor als Dispersion angesetzt und aufgedruckt worden, bei der im Wesentlichen das Lückenvolumen zwischen den Partikeln durch die wässrige, reaktive Lösung ausgefüllt wurde. Die Volumenkontraktion hat damit zur Folge, dass die Lösung zunächst etwas absinkt und einen Teil der Partikel 100 freilegt. Die zwischenzeitig ausgebildeten, metastabilen Phasen werden fixiert und die Partikel 100 werden fest auf dem Träger 300 verankert. Die Partikel 100 ragen schließlich über die ausgehärtete Reaktions-Lösungsschicht 201 hinaus. Die Partikel weisen somit im Endergebnis eine in der Reaktions-Lösungsschicht 201 verankerte Unterseite und eine über die Reaktions-Lösungsschicht 201 hinausragende Oberseite auf. Die begleitende Reaktion kommt dabei schrittweise zum Erliegen; je länger der Kontakt der Reaktionslösung 200, desto weiter ist die Lösungsreaktion während des Aushärtens fortgeschritten. Die Erfinder gehen davon aus, dass diese reaktive Konditionierung zumindest oberseitig einen die Kontaktzeit während des Aushärtens spiegelnden Gradienten in den Partikeln erzeugt, welcher die PV-Aktivität unterstützt und verbessert zugänglich macht.

In einem Schritt c) wird die Oberseite der Partikel 100 zumindest abschnittsweise mit einem Oberseiten-Kontakt 400 versehen.

So erhaltene PV-Schichtfolgen zeigen im konkreten Ausführungsbeispiel mit SiC-Partikeln zugängliche Potentialdifferenzen von mehreren Hundert Millivolt. Die Erfinder gehen davon aus, dass dies mit zusätzlichen Energiniveaus innerhalb der Bandlücke erklärt werden kann, welche auf die während der Reaktion erzeugten, substöchiometrischen Verbindungen und Defekte aus der Außenfläche der Partikel 100 zurückgeführt werden können. Mithin kann mit grundsätzlich bekannten, PV-aktiven Materialkombinationen, welche als homogene Partikel vorgelegt, reaktiv und dem beanspruchten Verfahren gemäß aufgedruckt und dabei in der Stöchiometrie geändert werden, auf besonders einfache und preiswerte Art eine PV-aktive Schichtfolge erzeugt werden. Beispiele für etablierte und mögliche, PV-aktive Materialkombinationen können veranschaulichend in der DE 39 36 666 C2 gefunden werden; gleichsinnig können bekannte Metall-Metalloxid sowie Metall-Metall-Halogenid-Kombinationen wie vorbeschrieben Verwendung finden.

Gemäß der vorliegenden Erfindung ist das Verfahren dadurch gekennzeichnet, dass die Partikel 100 in mindestens einem zusätzlichen Schritt in mindestens einem Flächenabschnitt oxidativ oder reduktiv konditioniert werden, wodurch Flächen reduktiv behandelter Partikel 102 oder Flächen oxidativ behandelter Partikel 103 vorgegeben werden. Im konkreten Ausführungsbeispiel konnte an SiC-Partikeln das Vorzeichen des abgreifbaren, photovoltaischen Stroms durch oxidativ/basische oder reduktiv/saure Konditionierung umgekehrt werden. Ein Dunkelstrom, welcher rein elektrochemsiche Prozesse indizieren würde, welche auch im Dunkelen und ohne Licht ablaufen, konnte dabei nicht gemessen werden. Die Erfinder gehen davon aus, dass hier mindestens zwei Niveaus innerhalb der Bandlücke durch oxidative oder reduktive Maßnahmen geflutet oder geleert wurden, sodass die Natur der Majoritätsladungsträger zwischen den beiden Energieniveaus je nach Konditionierung auf Akzeptor-Leitung oder auf Donor-Leitung eingestellt ist.

Bevorzugt ist das Verfahren dadurch gekennzeichnet, dass in einem weiteren Verfahrensschritt nanoskalige Strukturen umfassend mindestens eine Struktur ausgewählt aus der Gruppe bestehend aus Ketten, Netzen, Netz-Röhren im direkten Kontakt mit Partikeln 100 mindestens eines Fächenabschnitts, bevorzugt einem Flächenabschnitt auf der Oberseite, ausgebildet werden. Durch elektrische Koppelung mit unterschiedlich langen Atomketten oder Molekülketten kann eine Energieniveau zusätzlich modifiziert werden. Im konkreten Versuch ergaben Zusätze auf Basis von Ruß, Karbon-Nanoröhren sowie Kettenbildenden Halogenen und Metallhalogeniden in der Reaktionslösung 200 breitere und verbesserte Wellenlängenbereiche, in denen eine PV-Aktivität der PV-Schichtfolge feststellbar war. Dies kann mit einer elektrischen Kontaktierung und Modifikation der Partikel-Außenseite mit den Nano-Röhren und -Ketten sinnvoll erklärt werden.

Gemäß der vorliegenden Erfindung ist das Verfahren dadurch gekennzeichnet, dass aneinander angrenzende Flächenabschnitte der Partikel 100 mit unterschiedlichen Lösungen konditioniert werden, wobei wiederum die aneinander angrenzenden Flächenabschnitte der Partikel 100 in abwechselnder Reihenfolge als Abschnitte reduktiv behandelter Partikel 102 und Abschnitte oxidativ behandelter Partikel 103 ausgebildet werden. Besonders bevorzugt sind die Flächen jeweils als Kombination ausgebildet und mit engem Abstand zueinander angeordnet, wodurch ein Oberseitenkontakt 400 auf besonders einfache Weise eine Reihenschaltung der Teilflächen bereitstellen kann. Dadurch lassen sich Teilflächen untereinander zu einer Kaskade verbinden, in welcher das Potential der PV-Aktivität additiv verknüpft ist. Dies ergab im praktischen Versuch bei einer Anordnung auf einem Träger 300 aus Holz eine allein an der Oberseite kaskadierte, abgreifbare Spannung der aufgedruckten, partikulären PV-Schicht von 1 bis 2 Volt.

Bevorzugt ist das Verfahren dadurch gekennzeichnet, dass in mindestens einem weiteren Verfahrensschritt Elektroden, umfassend mindestens Träger-Elektrode 301 und/oder oberseitige Kontaktschicht 400, vorbereitend auf ein flächig erstrecktes Material aufgebracht und abschließend über das flächig erstreckte Material mit der PV-Schichtfolge verbunden werden. Besonders bevorzugt wird hierzu lufttrocknende und/oder reaktiv aushärtende Elektrodenlösung auf eine transparente Folie aufgedruckt und anschließend wird die Folie flächig in vorbestimmter Positionierung auf die gedruckte, PV-aktive Schicht aufgeklebt.

Bevorzugt ist das Verfahren dadurch gekennzeichnet, dass als Träger der PV-Schichtfolge endlos erstreckte, flächige Materialbahnen, bevorzugt Folienbahnen und/oder Papierbahnen, besonders bevorzugt Hanfpapierbahnen, verwendet werden. Hanf bietet den Vorteil, sulfatfrei gefertigt werden zu können; mit zusätzlichem Feuchtigkeitshemmer und/oder Biozid versehen kann solch ein Hanfpapier vorteilhaft hohen Temperaturen widerstehen, ohne zu vergilben oder mechanisch nennenswert zu verfallen oder in sienen Eigenschaften nachzulassen.

Bevorzugt ist das Verfahren dadurch gekennzeichnet, dass zerkleinerte, bevorzugt mechanisch zerkleinerte, Partikel 100 mit einer Korngröße von maximal 50 Mikrometern, bevorzugt mit einer Korngröße um 30 +- 15 Mikrometern, besonders bevorzugt mit einer Korngröße von 0,5 bis 10 Mikrometern, verwendet werden. Mechanisch zerkleinerte Partikel weisen Ecken und Kanten auf, welche im Druckverfahren verbessert in einen Träger eingedrückt und auf diesem verankert werden können.

Bevorzugt ist das Verfahren dadurch gekennzeichnet, dass die Kontaktelektroden auf einer Innenseite einer Einbettfolie aufgedruckt und/oder angeordnet werden und die verfahrensgemäß erhaltene PV-Schichtfolge in der Einbettfolie unter Erzeugung eines elektrotechnischen Kontakts, welcher aus der Einbettmasse herausgeführt ist, einlaminiert wird. Dies erlaubt besonders effizient die gleichzeitige Ausbildung und Kontaktierung ganzer Module wie es für Elektroden-Drähte auch in der DE 40 18 013 A beschrieben ist.

Weitere Vorteile und vorteilhafte Maßnahmen ergeben sich aus den Ausführungsbeispielen und der nachfolgenden Beschreibung. Die Ausführungsbeispiele sind dabei nicht beschränkend zu verstehen. Die beschriebenen, zusätzlichen Merkmale und zusätzlichen Maßnahmen sowie zusätzliche, vorteilhafte Maßnahmen und zusätzliche Merkmale, wie sie aus dem Stand der Technik bekannt sind, können im Rahmen der unabhängigen Ansprüche im beanspruchten Gegenstand vorteilhaft Anwendung finden, ohne dass der Bereich der Erfindung verlassen würde.

### KURZE BESCHREIBUNG DER FIGUREN

Die Figuren veranschaulichen in Prinzipskizzen gemäß...

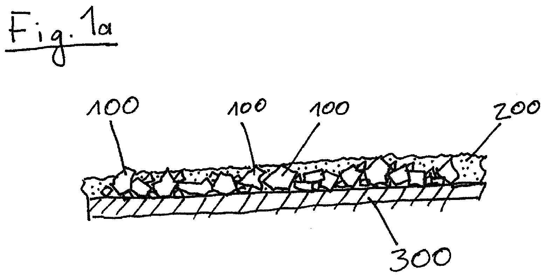

Fig.1a das Ergebnis von Schritt a) des Verfahrens, bei dem eine Schicht umfassend Partikel 100 in Reaktionslösung 200 auf einen Träger 300 aufgedruckt worden ist;

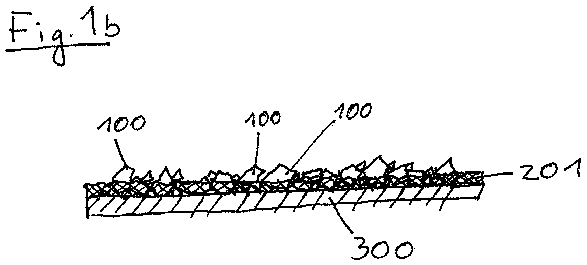

Fig. 1b das Ergebnis von Schritt b) des Verfahrens, bei dem die Reaktionslösung 200 zu einer dünneren Schicht, nämlich der ausgehärteten Reaktionslösung 201, ausgehärtet wurde, bei der Partikel 100 nun unterseitig durch die ausgehärtete Schicht auf dem Träger 300 verankert sind und oberseitig aus der ausgehärteten Reaktionslösung 201 herausragen;

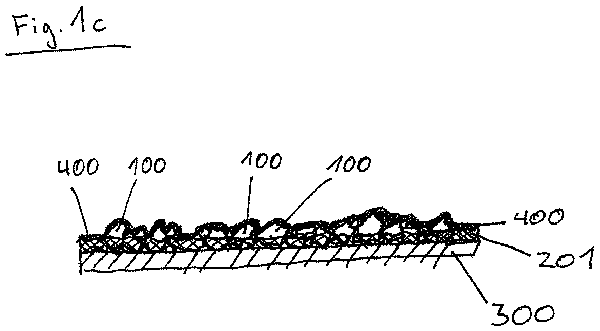

Fig. 1C eine Schicht gemäß Fig. 1a) und 1b) nach abschließendem Aufbringen eines Oberseitenkontakts 400;

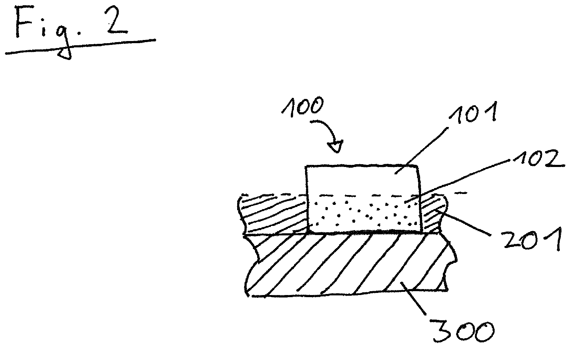

Fig.2 ein Partikel 100 mit Oberseite 101 und reduktiv behandelter Unterseite 102 in verfahrensgemäßer Verankerung per ausgehärteter Reaktionslösung 201 auf einem Träger 300;

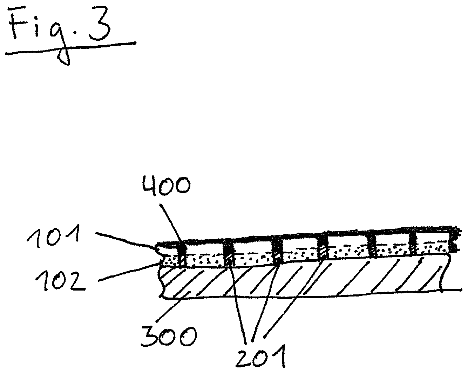

Fig. 3 eine Anordnung und Kontaktierung von gedruckten Teilflächen von Partikeln 100 gemäß Fig. 2 in einer einfachen PV-Schichtfolge mit unterseitiger Gegen-Elektrode (nicht abgebildet);

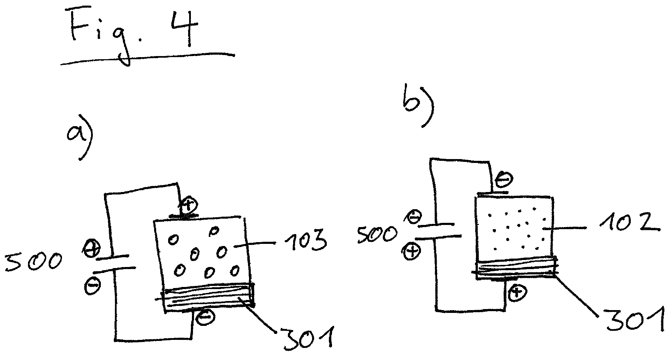

Fig. 4 mögliche Verschaltung und resultierende Vorzeichen von verdruckten Teilflächen einer PV-Schichtfolge aufweisend a) oxidativ behandelte Abschnitte 103 und b) reduktiv behandelte Abschnitte 102, wobei jeweils eine unterseitige Träger-Elektrode 301 und ein oberseitig angebrachter Abnahme-Kontakt den Abschnitt mit einer PV-Messbaugruppe 500, hier veranschaulicht als Kondensator, verbinden;

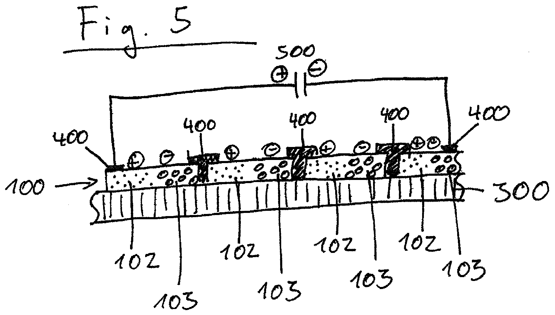

Fig. 5 mögliche Verschaltung einer Abfolge von auf einen Träger 300 aufgedruckten Teilabschnitten umfassend Partikel 100, wobei in jedem Teilabschnitt ein oxidativ behandelter Abschnitt 102 mit einem reduktiv behandelten Abschnitt 103 kombiniert ist und sämtliche Teilabschnitte über Oberseitenkontakte 400 in Reihe kaskadiert und die Kaskade mit einer PV-Messbaugruppe 500 verbunden ist;

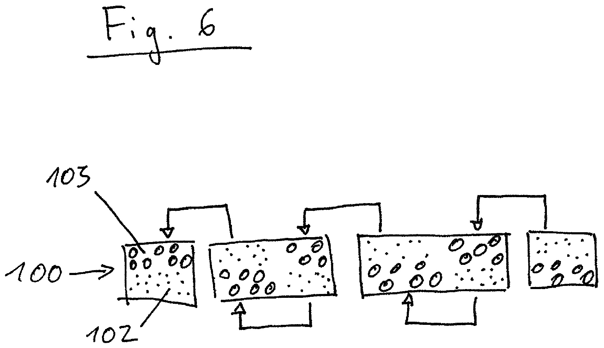

Fig. 6 mögliche Stromführung aufgedruckter Teilabschnitte umfassend Partikel 100, wobei reduktiv behandelte Abschnitte 102 und oxidativ behandelte Abschnitte 103 sowohl in den Abschnitten als auch untereinander per Kontaktierung kaskadiert angerodnet sind;

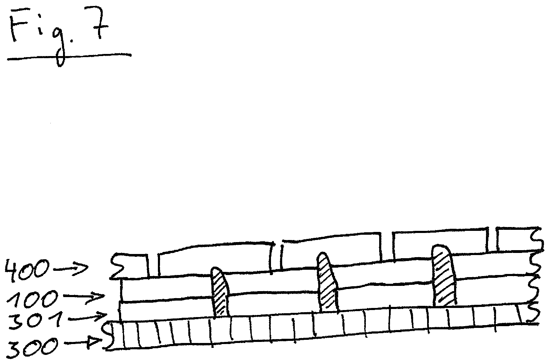

Fig. 7 Anordnung einer Schichtenfolge umfassend einen Träger 300, eine bodenseitige Träger-Elektrode 301, Abschnitte umfassend Partikel 100 und Oberseitenkontakte 400;

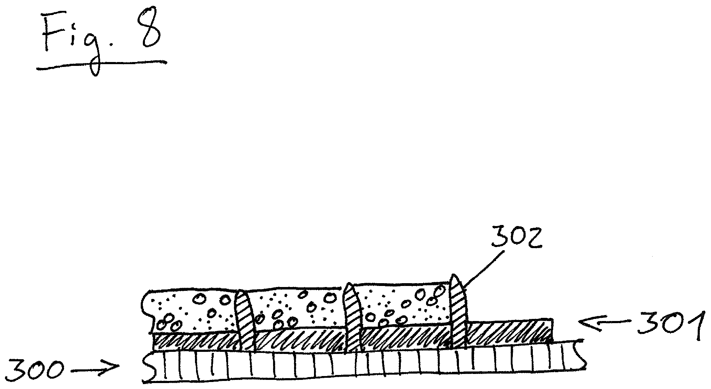

Fig. 8 Anordnung gemäß Figur 7 in Teildarstellung mit den hervorgehobenen Elementen Träger 300, Träger-Elektrode 301 und im Reliefdruck gefertigter, nicht leitender Umrandung 302;
Fig. 9 REM-Aufnahme und gleichsinnig gefertigte Prinzipskizze mit Bezugszeichen einer PV Schichtfolge nach dem Stand der Technik, aufweisend die Oberfläche einer Cu-Ni Rückseitenelektrode 601, an welche sich im Schnitt betrachtet nach der Rückseitenelektrode 602 eine TCO-Schicht 603 anschließt, eine PV-aktive Schicht 604 auf Si-Basis mit TCO-Deckschicht und AR-Deckschicht anschließen und schließlich der oberseitige Glasträger 605 mit Oberseite anschließt; gemäß Maßstab 606 mit 5 Mikrometern ist der gesamte Schichtverbund wenige Mikrometer dick;
Fig. 10 REM-Aufnahme und gleichsinnig gefertigte Prinzipskizze mit Bezugszeichen einer verfahrensgemäßen PV Schichtfolge, aufweisend mechanisch zerkleinerte und mit Reaktionslösung konditionierte und fixierte Partikel 701, welche von ausgehärteter, glasartig amorpher Reaktionslösung 702 überzogen und fixiert werden, wobei der Maßstab 703 mit 20 Mikrometern die deutlich abweichenden Größenverhältnisse der Morphologie veranschaulicht;
Fig. 11 REM-Aufnahme und gleichsinnig gefertigte Prinzipskizze mit Bezugszeichen einer verfahrensgemäßen PV Schichtfolge, aufweisend die Phasen 801 und 802, welche interpenetrierend ausgebildet sind und Partikel 803 verankernd umschließen, wobei der Maßstab 804 mit 5 Mikrometern die deutlich abweichenden Größenverhältnisse der Morphologie veranschaulicht.

### DETAILLIERTE ERLÄUTERUNG DER ERFINDUNG AN HAND VON

### AUSFÜHRUNGBEISPIELEN

In vorteilhafter Ausführungsform wurde ein Verfahren durchgeführt, bei dem in einem Schritt a) maximal 30 +- 15 Mikrometer große, halbleitende, technisch reine Partikel 100 aus SiC in einer wässrigen Reaktionslösung 200 bestehend aus mit Natronlauge alkalisch eingestellter Kieselsäurelösung unter leichter Gasentwicklung dispergiert, oxidativ angelöst und flächig auf Abschnitte eines Folien- und/oder Papier-Trägers 300 mit zuvor aufgebrachter Trägerelektrode 301, und bevorzugt mit zusätzlich aufgedruckter Umrandung 302, aufgebracht werden,
- in einem Schritt b) die Reaktionslösung 200 unter Volumenkontraktion zu einer ausgehärteten Reaktions-Lösungsschicht 201 umgewandelt wird, wobei die Partikel 100 über die ausgehärtete Reaktions-Lösungsschicht 201 hinausragen und eine in der Reaktions-Lösungsschicht 201 verankerte Unterseite und eine über die Reaktions-Lösungsschicht 201 hinausragende Oberseite aufweisen,
- oberseitige Flächenabschnitte oxidativ oder reduktiv konditioniert werden, wodurch Flächen reduktiv behandelter Partikel 102 oder Flächen oxidativ behandelter Partikel 103 vorgegeben werden, wobei wiederum
- nanoskalige Strukturen umfassend mindestens eine Struktur ausgewählt aus der Gruppe bestehend aus Ketten, Netzen, Netz-Röhren, bevorzugt CNT- und/oder Halogen-Ketten, im direkten Kontakt mit Partikeln 100 mindestens eines Fächenabschnitts ausgebildet werden, und
- aneinander angrenzende Flächenabschnitte der Partikel 100 mit unterschiedlichen Lösungen konditioniert werden, wobei die aneinander angrenzende Flächenabschnitte der Partikel 100 in abwechselnder Reihenfolge als Abschnitte reduktiv behandelter Partikel 102 und Abschnitte oxidativ behandelter Partikel 103 ausgebildet werden,
- in einem Schritt c) die Oberseite der Partikel zumindest abschnittsweise mit einem Oberseiten-Kontakt 400 versehen wird und die alternierend konditionierten Flächen-Abschnitte der Partikel 100 in Reihe verbunden und mit abschließenden Kontaktelektroden verbunden werden.

Als Halogenid-Ketten bildender Zusatz wurde Lugol'sche Lösung mit wenigen Gewichstprozent Anteil der Reaktionslösung 200 zugesetzt.

Als Elastizitäts-Stellstoff wurde ein wasserdispergierbarer Stärkepolyether mit 0,1 bis 2 Gewichtsprozent der Reaktionslösung zugesetzt.

Als Hilfsstoff zur Konditionierung wurde einerseits ein wässriges, saures Tensid und andererseits ein wässriges, alkalisches Polyol verwendet, wobei das Tensid und das Polyol als Benetzungshilfen fungieren über die wässrige Phase mit verdampfbar sind; beide Hilfsstoffe wurden zur Konditionierung ausgehärteter Abschnitte flächig mit etwa 1 Gramm pro Quadratmeter in dünner bis dünnster Schicht aufgedruckt und die verdampfende, wässrige Phase wurde abgesaugt. Gemäß den veranschaulichenden Figuren machen unterschiedliche Kontaktierungen sehr verschiedene Vorteile und Anwendungen zugänglich. Direkte Kaskadierungen einer einzelnen Abschnittsfolge erlauben das Abgreifen photovoltaischer Potentiale, welche präzise das vorhandene Licht in seiner Intensität abbilden; gedruckte Photosensoren sind so zugänglich. Flächige Elektroden und optimierte Abschnittsgrößen und Schichtdicken maximieren hingegen den verfügbaren Strom und bieten die Möglichkeit, mit einer Norm-Effizienz um 10% die gedruckte PV-Schichtkombination als klassische PV-Stromquelle heranzuziehen. Eine Kombination aus beiden Maßnahmen erlaubt das Anpassen der verfügbaren Maximalspannung, um gezielt für bestimmte Geräte oder Applikationen notwendige Spannungen bereitzustellen.

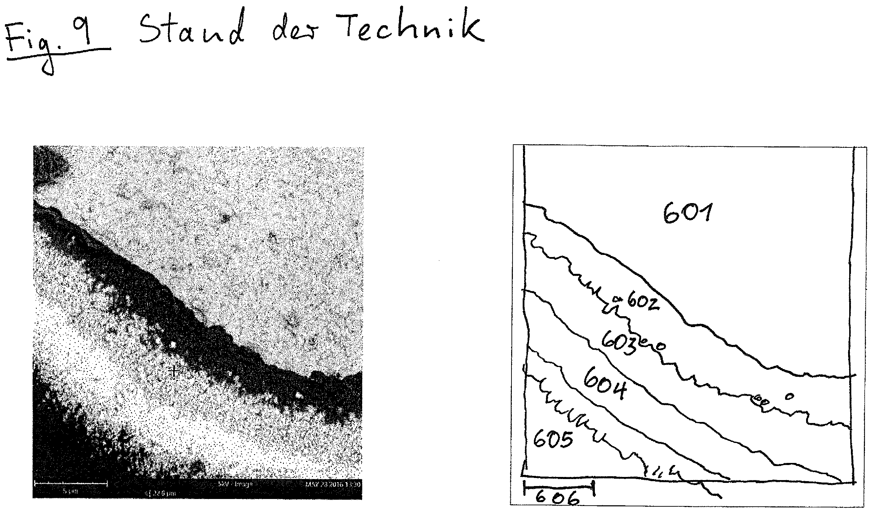

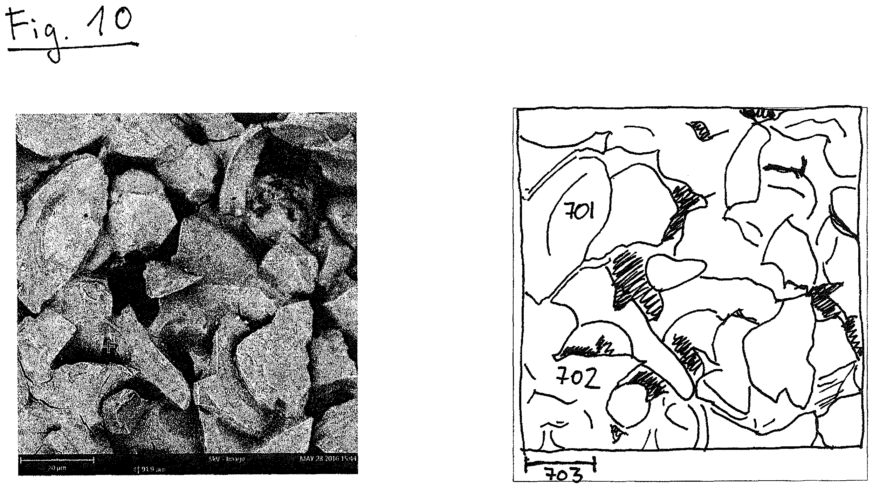

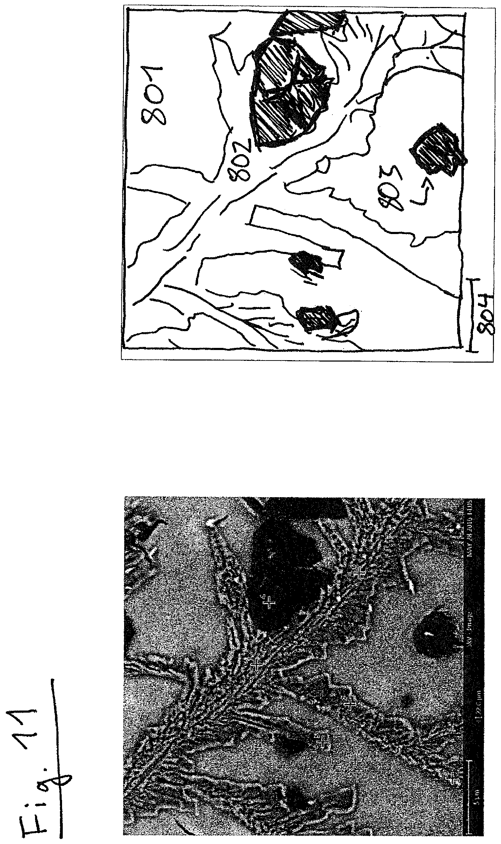

Die Figuren 9 bis 11 veranschaulichen auch die morphologisch stark abweichenden Eigenschaften der verfahrensgemäßen Produkte: Abweichend zu etablierten Systemen und PV-Schichten, welche durch Kovaporation oder andere Gasphasen-Produkte erhältlich sind, wirken die übergroßen Brocken und groben Teilchen des erfindungsgemäßen Verfahrens geradezu grobschlächtig. Durch die speziellen Verfahrensmaßnahmen gelingt es jedoch, diese günstigen, verfügbaren und technsich reinen Rohstoffe sinnvoll und extrem kostengünstig in eine langlebige und konkurrenzfähige PV-Schichtenfolge einzuarbeiten.

### INDUSTRIELLE ANWENDBARKEIT

Nachteilig ist bei etablierten PV-Schichtfolgen und entsprechenden Herstellungsverfahren, dass diese verfahrenstechnisch aufwändig sind und teure, reine Ausgangsstoffe erfordern, um zuverlässig die PV-Aktivität bereitstellen zu können.

Aufgabe war es daher, die Nachteile zu überwinden und ein Verfahren und eine verfahrensgemäße PV-Schichtfolge bereitzustellen, welche trotz niedrigster Herstellungskosten zuverlässig und langlebig eine PV-Funktion bereitstellen kann.

Die Lösung erfolgt durch eine reaktive Konditionierung anorganischer Partikel im Rahmen eines Raumtemperatur-Druckverfahrens; die oberflächliche, reaktive Konditionierung stellt die PV-Aktivität präzise ein, liefert ein kinetisch kontrolliertes Reaktionsprodukt und kann selbst bei technisch reinen Ausgangsstoffen mit Reinheiten um 97% die angestrebte PV-Aktivität gewährleisten.

### BEZUGSZEICHENLISTE ANSPRÜCHE

- 100: Partikel
- 101: Oberseite
- 102: reduktiv behandelter Abschnitt
- 103: oxidativ behandelter Abschnitt

- 200: Reaktionslösung
- 201: ausgehärtete Reaktionslösung

- 300: Träger
- 301: Träger-Elektrode
- 302: Umrandung (z. B. Reliefdruck)

- 400: Oberseitenkontakt

### BEZUGSZEICHENLISTE BESCHREIBUNG

- 100: Partikel
- 101: Oberseite
- 102: reduktiv behandelter Abschnitt
- 103: oxidativ behandelter Abschnitt
- 200: Reaktionslösung
- 201: ausgehärtete Reaktionslösung
- 300: Träger
- 301: Träger-Elektrode
- 302: Umrandung (Reliefdruck)
- 400: Oberseitenkontakt
- 500: PV-Messbaugruppe
- 601: Rückseitenelektrode
- 602: Rückseitenelektrode in Schnittsicht
- 603: TCO-Schicht
- 604: PV-aktive Si-Schicht mit TCO-Deckschicht und AR-Deckschicht
- 605: Glasträger und Oberseite
- 606: 5 Mikrometer Maßstab
- 701: mit Reaktionslösung konditionierte Partikel
- 702: ausgehärtete, glasartig amorphe Reaktionslösung
- 703: 20 Mikrometer Maßstab
- 801: Phase 1 einer Matrix aus zwei interpenetrierenden Phasen
- 802: Phase 2 einer Matrix aus zwei interpenetrierenden Phasen
- 803: in der Matrix verankerte Partikel
- 804: 5 Mikrometer Maßstab

## Patentansprüche

1. Verfahren zur Herstellung einer PV-Schichtfolge, bei dem
- bei Raumtemperatur,
- anorganische Kernkomponenten
- unter Verwendung wässriger Lösungen oder wässriger Dispersionen per Druckverfahren zu einer vollständigen, über Elektroden kontaktierbaren PV-Schichfolge verarbeitet werden, wobei das Verfahren die Schritte umfasst, dass
- in einem Schritt a) 0,5 bis 100 Mikrometer große, halbleitende Partikel (100), welche aus mindestens zwei Elementen bestehen, in einer wässrigen Reaktionslösung (200) dispergiert, oxidativ oder reduktiv angelöst und flächig auf einen Träger (300) aufgebracht werden,
- in einem Schritt b) die Reaktionslösung (200) unter Volumenkontraktion zu einer ausgehärteten Reaktions-Lösungsschicht (201) umgewandelt wird, wobei die Partikel (100) über die ausgehärtete Reaktions-Lösungsschicht (201) hinausragen und eine in der Reaktions-Lösungsschicht (201) verankerte Unterseite und eine über die Reaktions-Lösungsschicht (201) hinausragende Oberseite aufweisen,
- in einem Schritt c) die Oberseite der Partikel zumindest abschnittsweise mit einem Oberseiten-Kontakt (400) versehen wird,
**dadurch gekennzeichnet, dass** im Schritt b) weiterhin
- aneinander angrenzende Flächenabschnitte der Partikel (100) mit unterschiedlichen Lösungen konditioniert werden, wodurch die aneinander angrenzenden Flächenabschnitte der Partikel (100) in abwechselnder Reihenfolge als Abschnitte reduktiv behandelter Partikel (102) und Abschnitte oxidativ behandelter Partikel (103) ausgebildet werden.

2. Verfahren nach dem vorhergehenden Anspruch, **dadurch gekennzeichnet, dass** die Partikel (100) in mindestens einem zusätzlichen Schritt in mindestens einem Flächenabschnitt oxidativ oder reduktiv konditioniert werden, wodurch Flächen reduktiv behandelter Partikel (102) oder Flächen oxidativ behandelter Partikel (103) vorgegeben werden.

3. Verfahren nach einem der vorhergehenden Ansprüche, **dadurch gekennzeichnet, dass** in einem weiteren Verfahrensschritt nanoskalige Strukturen umfassend mindestens eine Struktur ausgewählt aus der Gruppe bestehend aus Ketten, Netzen, Netz-Röhren im direkten Kontakt mit Partikeln (100) mindestens eines Fächenabschnitts, bevorzugt einem Flächenabschnitt auf der Oberseite, ausgebildet werden.

4. Verfahren nach einem der vorhergehenden Ansprüche, **dadurch gekennzeichnet, dass** in mindestens einem weiteren Verfahrensschritt Elektroden, umfassend mindestens Träger-Elektrode (301) oder oberseitige Kontaktschicht (400), vorbereitend auf ein flächig erstrecktes Material aufgebracht und abschließend über das flächig erstreckte Material mit der PV-Schichtfolge verbunden werden.

5. Verfahren nach einem der vorhergehenden Ansprüche, **dadurch gekennzeichnet, dass** als Träger der PV-Schichtfolge endlos erstreckte, flächige Materialbahnen, bevorzugt Folienbahnen oder Papierbahnen, besonders bevorzugt Hanfpapierbahnen, verwendet werden.

6. Verfahren nach einem der vorhergehenden Ansprüche, **dadurch gekennzeichnet, dass** zerkleinerte, bevorzugt mechanisch zerkleinerte, Partikel (100) mit einer Korngröße von maximal 50 Mikrometern, bevorzugt mit einer Korngröße um 30 +- 15 Mikrometern, besonders bevorzugt mit einer Korngröße von 0,5 bis 10 Mikrometern, verwendet werden.

7. Verfahren nach einem der vorhergehenden Ansprüche, **dadurch gekennzeichnet, dass** in einem Schritt a) maximal 15 bis 45 Mikrometer große, halbleitende Partikel (100) aus SiC in einer wässrigen Reaktionslösung (200) bestehend aus mit Natronlauge alkalisch eingestellter Kieselsäurelösung unter leichter Gasentwicklung dispergiert, oxidativ angelöst und flächig auf Abschnitte eines Folien- oder Papier-Trägers (300) mit zuvor aufgebrachter Trägerelektrode (301), und bevorzugt mit zusätzlich aufgedruckter Umrandung (302), aufgebracht werden,
- in einem Schritt b) die Reaktionslösung (200) unter Volumenkontraktion zu einer ausgehärteten Reaktions-Lösungsschicht (201) umgewandelt wird, wobei die Partikel (100) über die ausgehärtete Reaktions-Lösungsschicht (201) hinausragen und eine in der Reaktions-Lösungsschicht (201) verankerte Unterseite und eine über die Reaktions-Lösungsschicht (201) hinausragende Oberseite aufweisen,
- oberseitige Flächenabschnitte oxidativ oder reduktiv konditioniert werden,
wodurch Flächen reduktiv behandelter Partikel (102) oder Flächen oxidativ behandelter Partikel (103) vorgegeben werden, wobei wiederum
- nanoskalige Strukturen umfassend mindestens eine Struktur ausgewählt aus der Gruppe bestehend aus Ketten, Netzen, Netz-Röhren, bevorzugt CNT- oder Halogen-Ketten, im direkten Kontakt mit Partikeln (100) mindestens eines Fächenabschnitts ausgebildet werden, und
- aneinander angrenzende Flächenabschnitte der Partikel (100) mit unterschiedlichen Lösungen konditioniert werden, so dass die aneinander angrenzende Flächenabschnitte der Partikel (100) in abwechselnder Reihenfolge als Abschnitte reduktiv behandelter Partikel (102) und Abschnitte oxidativ behandelter Partikel (103) ausgebildet werden,
- in einem Schritt c) die Oberseite der Partikel zumindest abschnittsweise mit einem Oberseiten-Kontakt (400) versehen wird und die alternierend konditionierten Flächen-Abschnitte der Partikel (100) in Reihe verbunden und mit abschließenden Kontaktelektroden verbunden werden.

8. Verfahren nach einem der vorhergehenden Ansprüche, **dadurch gekennzeichnet, dass** die Kontaktelektroden auf einer Innenseite einer Einbettfolie aufgedruckt oder angeordnet werden und die verfahrensgemäß erhaltene PV-Schichtfolge in der Einbettfolie unter Erzeugung eines elektrotechnischen Kontakts, welcher aus der Einbettmasse herausgeführt ist, einlaminiert wird.

9. PV-Schichtfolge erhalten nach einem der vorhergehenden Verfahrensansprüche, aufweisend eine bei Raumtemperatur ausgehärtete, wässrige Reaktions-Lösungsschicht (201), wobei Partikel (100) aus anorganischen Kernkomponenten über die ausgehärtete Reaktions-Lösungsschicht (201) hinausragen und eine in der Reaktions-Lösungsschicht (201) verankerte Unterseite und eine über die Reaktions-Lösungsschicht (201) hinausragende Oberseite aufweisen, die PV-Schichtfolge weiterhin umfassend aufgedruckte Elektroden, welche die PV-Schichfolge kontaktieren, wobei wiederum
- als Partikel (100) 0,5 bis 100 Mikrometer große, halbleitende Partikel (100), oxidativ oder reduktiv angelöst und flächig auf einem Träger (300) angeordnet sind,
- die Oberseite der Partikel zumindest abschnittsweise mit einem Oberseiten-Kontakt (400) versehen ist,
- aneinander angrenzende Flächenabschnitte der Partikel (100) mit unterschiedlichen Lösungen konditioniert sind, wodurch die aneinander angrenzenden Flächenabschnitte der Partikel (100) in abwechselnder Reihenfolge als Abschnitte reduktiv behandelter Partikel (102) und Abschnitte oxidativ behandelter Partikel (103) angeordnet sind.

## Claims

1. Method for producing a PV layer sequence, in which
- at room temperature,
- inorganic core components are processed
- using aqueous solutions or aqueous dispersions
by means of printing methods to form a complete PV layer which can be contacted via electrodes, the method comprising the steps that
- in a step a), semiconductor particles (100), which are 0.5 to 100 micrometers in size and consist of at least two elements, are dispersed in an aqueous reaction solution (200), are oxidatively or reductively etched and are applied over the surface of a substrate (300),
- in a step b), the reaction solution (200) is converted into a cured reaction solution layer (201) with volume contraction, the particles (100) projecting above the cured reaction solution layer (201) and having an underside, which is anchored in the reaction solution layer (201), and an upper side, which projects above the reaction solution layer (201),
- in a step c), the upper side of the particles is provided, at least in portions, with an upper-side contact (400),
**characterized in that,** also in step b),
- adjacent surface portions of the particles (100) are conditioned using different solutions, whereby the adjacent surface portions of the particles (100) are formed as an alternating sequence of portions of reductively treated particles (102) and portions of oxidatively treated particles (103),

2. Method according to the preceding claim, **characterized in that,** in at least one additional step, the particles (100) are oxidatively or reductively conditioned in at least one surface portion, as a result of which surfaces of reductively treated particles (102) or surfaces of oxidatively treated particles (103) are defined.

3. Method according to either of the preceding claims, **characterized in that,** in a further method step, nanoscale structures, comprising at least one structure selected from the group consisting of chains, meshes and mesh tubes, are formed in direct contact with particles (100) of at least one surface portion, preferably a surface portion on the upper side.

4. Method according to any of the preceding claims, **characterized in that,** in at least one further method step, electrodes, comprising at least the substrate electrode (301) or upper-side contact layer (400), are preliminarily applied to a material extended over the surface and are then connected to the PV layer sequence via the material extended over the surface.

5. Method according to any of the preceding claims, **characterized in that** continuously extended, flat material webs, preferably film webs or paper webs, particularly preferably hemp paper webs, are used as the substrate of the PV layer sequence.

6. Method according to any of the preceding claims, **characterized in that** comminuted, preferably mechanically comminuted, particles (100) having a particle size of no more than 50 micrometers, preferably having a particle size of around 30 +-15 micrometers, particularly preferably having a particle size of from 0.5 to 10 micrometers, are used.

7. Method according to any of the preceding claims, **characterized in that,** in a step a), semiconductor SiC particles (100), which are no more than 15 to 45 micrometers in size, are dispersed in an aqueous reaction solution (200) consisting of silicic acid solution, which is alkali-adjusted with sodium hydroxide solution, with slight gas evolution, are oxidatively etched and are applied over the surface of portions of a film or paper substrate (300) having the previously applied substrate electrode (301), and preferably having an additionally printed border (302),
- in a step b), the reaction solution (200) is converted into a cured reaction solution layer (201) with volume contraction, the particles (100) projecting above the cured reaction solution layer (201) and having an underside, which is anchored in the reaction solution layer (201), and an upper side, which projects above the reaction solution layer (201),
- upper-side surface portions are oxidatively or reductively conditioned, as a result of which surfaces of reductively treated particles (102) or surfaces of oxidatively treated particles (103) are defined, in turn
- nanoscale structures, comprising at least one structure selected from the group consisting of chains, lattices and lattice tubes, preferably CNT or halogen chains, being formed in direct contact with particles (100) of at least one surface portion, and
- adjacent surface portions of the particles (100) being conditioned using different solutions, so that the adjacent surface portions of the particles (100) being formed in an alternating sequence as portions of reductively treated particles (102) and portions of oxidatively treated particles (103),
- in a step c), the upper side of the particles being provided, at least in portions, with an upper-side contact (400) and the alternatingly conditioned surface portions of the particles (100) being connected in series and being connected to terminating contact electrodes.

8. Method according to any of the preceding claims, **characterized in that** the contact electrodes are printed or arranged on an inner side of an embedding film and the PV layer sequence obtained according to the method is laminated into the embedding film to produce an electrical contact which is guided out of the embedding compound.

9. PV layer sequence obtained according to any of the preceding method claims, comprising an aqueous reaction solution layer (201) which is cured at room temperature, wherein particles (100) made of inorganic core components project above the cured reaction solution layer (201) and have an underside, which is anchored in the reaction solution layer (201), and an upper side, which projects above the reaction solution layer (201),
the PV layer sequence further comprising printed electrodes which contact the PV layer sequence, wherein in turn
- as particles (100), semiconductor particles (100), which are 0.5 to 100 micrometers in size, are oxidatively or reductively etched and are arranged over the surface of a substrate (300),
- the upper side of the particles is provided, at least in portions, with an upper-side contact (400),
- adjacent surface portions of the particles (100) are conditioned using different solutions, whereby the adjacent surface portions of the particles (100) are in turn arranged in an alternating sequence as portions of reductively treated particles (102) and portions of oxidatively treated particles (103).

## Revendications

1. Procédé de fabrication d'une succession de couches PV, dans lequel
- à température ambiante,
- des composants de base inorganiques
- à l'aide de solutions aqueuses ou de dispersions aqueuses
sont traités par un procédé d'impression en une succession de couches PV complète pouvant être mise en contact avec des électrodes, le procédé comprenant les étapes en ce que
- dans une étape a), des particules (100) semi-conductrices d'une taille allant de 0,5 à 100 micromètres et constituées d'au moins deux éléments sont dispersées dans une solution réactionnelle (200) aqueuse, corrodés par oxydation ou par réduction et appliquées en surface sur un support (300),
- dans une étape b), la solution réactionnelle (200) est transformée par contraction de volume en une couche de solution réactionnelle (201) durcie, les particules (100) faisant saillie au-delà de la couche de solution réactionnelle (201) durcie et présentant un côté inférieur ancré dans la couche de solution réactionnelle (201) et un côté supérieur faisant saillie au-delà de la couche de solution réactionnelle (201),
- dans une étape c), le côté supérieur des particules est pourvu, au moins dans certaines sections, d'un contact de côté supérieur (400),
**caractérisé en ce que,** en outre, dans l'étape b),
- des sections de surface adjacentes des particules (100) sont conditionnées avec différentes solutions, de sorte que les sections de surface adjacentes des particules (100) étant à leur tour réalisées dans un ordre en alternance sous forme de sections de particules traitées par réduction (102) et de sections de particules traitées par oxydation (103).

2. Procédé selon la revendication précédente, **caractérisé en ce que** les particules (100), dans au moins une étape supplémentaire, sont conditionnées par oxydation ou par réduction dans au moins une section de surface, moyennant quoi des surfaces de particules traitées par réduction (102) ou des surfaces de particules traitées par oxydation (103) sont prédéfinies.

3. Procédé selon l'une des revendications précédentes, **caractérisé en ce que,** dans une étape de procédé supplémentaire, des structures nanométriques comprenant au moins une structure choisie dans le groupe constitué par des chaînes, des filets, des tubes filetés en contact direct avec des particules (100) d'au moins une section de surface, de préférence une section de surface sur le côté supérieur, sont réalisées.

4. Procédé selon l'une des revendications précédentes, **caractérisé en ce que,** dans au moins une étape de procédé supplémentaire, des électrodes comprenant au moins une électrode de support (301) ou une couche de contact côté supérieur (400) sont appliquées au préalable sur un matériau étendu en surface et sont finalement reliées à la succession de couches PV par l'intermédiaire du matériau étendu en surface.

5. Procédé selon l'une des revendications précédentes, **caractérisé en ce que** des bandes de matériau plates s'étendant sans fin, de préférence des bandes de film ou des bandes de papier, de manière particulièrement préférée des bandes de papier de chanvre, sont utilisées comme support de la succession de couches PV.

6. Procédé selon l'une des revendications précédentes, **caractérisé en ce que** des particules (100) broyées, de préférence broyées mécaniquement, comportant une taille de grains de 50 micromètres au maximum, de préférence comportant une taille de grains de 30 +- 15 micromètres, de manière particulièrement préférée comportant une taille de grains de 0,5 à 10 micromètres, sont utilisées.

7. Procédé selon l'une des revendications précédentes, **caractérisé en ce que,** dans une étape a), des particules (100) semi-conductrices de SiC, d'une taille allant de 15 à 45 micromètres au maximum, sont dispersées dans une solution réactionnelle (200) aqueuse, constituée d'une solution d'acide silicique alcalinisée avec de la soude caustique, avec un léger dégagement de gaz, corrodés par oxydation et appliquées en surface sur des sections d'un support (300) en film ou en papier comportant une électrode de support (301) préalablement appliquée, et de préférence comportant en outre une bordure imprimée (302),
- dans une étape b), la solution réactionnelle (200) est transformée par contraction de volume en une couche de solution réactionnelle (201) durcie, les particules (100) faisant saillie au-delà de la couche de solution réactionnelle (201) durcie et présentant un côté inférieur ancré dans la couche de solution réactionnelle (201) et un côté supérieur faisant saillie au-delà de la couche de solution réactionnelle (201),
- des sections de surface côté supérieur sont conditionnées par oxydation ou par réduction,
moyennant quoi des surfaces de particules traitées par réduction (102) ou des surfaces de particules traitées par oxydation (103) sont prédéfinies, à leur tour,
- des structures nanométriques comprenant au moins une structure choisie dans le groupe constitué par des chaînes, des filets, des tubes filetés, de préférence des chaînes NCT ou des chaînes halogénées, étant réalisées en contact direct avec des particules (100) d'au moins une section de surface,
- des sections de surface adjacentes des particules (100) étant conditionnées avec différentes solutions, de sorte que les sections de surface adjacentes des particules (100) étant réalisées dans un ordre en alternance sous forme de sections de particules traitées par réduction (102) et de sections de particules traitées par oxydation (103),
- dans une étape c), le côté supérieur des particules étant pourvu, au moins dans certaines sections, d'un contact de côté supérieur (400) et les sections de surface conditionnées de manière alternée des particules (100) étant reliées en série et étant reliées à des électrodes de contact finales.

8. Procédé selon l'une des revendications précédentes, **caractérisé en ce que** les électrodes de contact sont imprimées ou disposées sur un côté intérieur d'un film d'enrobage et la succession de couches PV obtenue selon le procédé est stratifiée dans le film d'enrobage en produisant un contact électrotechnique qui est extrait de la matière d'enrobage.

9. Succession de couches PV obtenue selon l'une des revendications de procédé précédentes, présentant une couche de solution réactionnelle (201) aqueuse durcie à température ambiante, des particules (100) de composants de base inorganiques faisant saillie au-delà de la couche de solution réactionnelle (201) durcie et présentant un côté inférieur ancré dans la couche de solution réactionnelle (201) et un côté supérieur faisant saillie au-delà de la couche de solution réactionnelle (201),
la succession de couches PV comprenant en outre des électrodes imprimées qui sont en contact avec la succession de couches PV, à leur tour,
- en tant que particules (100), des particules (100) semi-conductrices d'une taille allant de 0,5 à 100 micromètres étant corrodés par oxydation ou par réduction et disposées en surface sur un support (300),
- le côté supérieur des particules étant pourvu, au moins dans certaines sections, d'un contact de côté supérieur (400),
- des sections de surface adjacentes des particules (100) étant conditionnées avec différentes solutions, de sorte que les sections de surface adjacentes des particules (100) étant disposées dans un ordre en alternance sous forme de sections de particules traitées par réduction (102) et de sections de particules traitées par oxydation (103).
